# EUROPEAN PATENT SPECIFICATION

(11) **EP 1 928 218 B1**
(45) Date of publication and mention of the grant of the patent: **11.04.2012**
(21) Application number: 06798130.8
(22) Date of filing: 20.09.2006
(51) Int. Cl.: H05K 1/14, H05K 3/36

(54) **FLEXIBLE PRINTED WIRING BOARD AND METHOD FOR MANUFACTURING SAME**
FLEXIBLE GEDRUCKTE LEITERPLATTE UND VERFAHREN ZU DESSEN HERSTELLUNG
CARTE IMPRIMEE FLEXIBLE ET SON PROCEDE DE FABRICATION

(30) Priority: 20.09.2005 JP 2005272490
(43) Date of publication of application: 04.06.2008
(73) Proprietor: Sumitomo Electric Industries, Ltd., Osaka-shi, Osaka 541-0041 (JP); Sumitomo Electric Printed Circuits, Inc., Kouga-shi, Shiga 528-0068 (JP)
(72) Inventor: KASHIHARA, Hideki, Osaka-shi Osaka 554-0024 (JP); KOYAMA, Keiji, Osaka-shi Osaka 554-0024 (JP); NAKAYAMA, Shuichi, Kouga-shi Shiga 528-0068 (JP)
(74) Representative: Cross, Rupert Edward Blount
(86) International application number: PCT/JP2006/318570
(87) International publication number: WO 2007/034801

(56) References cited:
- JP-A- 06 268 348
- JP-A- 2001 156 418
- JP-A- 2001 156 418
- JP-A- 2005 146 043
- JP-A- 2005 146 043
- US-A- 4 731 282

## Description

### TECHNICAL FIELD

The present invention relates to a flexible printed circuit board used as a component for an electronic device, and to a method for manufacturing the same.

### BACKGROUND ART

In the field of electronic devices, as densification of electronic components takes place, flexible printed circuit boards have been widely used to provide wiring for movable parts of the electronic devices. Also, as the size of electronic devices is reduced and the functionality of electronic devices is improved, flexible printed circuit boards formed by connecting several flexible printed circuit boards have been used.

A structure for connecting several flexible printed circuit boards includes, for example, a connecting structure that uses a connector disclosed in patent document 1. According to the publication, a conductive circuit layer is formed on a connector connecting portion of a flexible printed circuit board with its surface being exposed. A connecting terminal used for connecting the flexible printed circuit board to another flexible printed circuit board is formed on the conductive circuit layer. The connecting terminal is inserted in a connector provided on another flexible printed circuit board.

Furthermore, a structure in which flexible printed circuit boards are connected using an anisotropic conductive adhesive is disclosed in patent document 2. According to the publication, metal bumps provided on a first flexible printed circuit board and connection pads provided on a second flexible printed circuit board are electrically connected with each other via the anisotropic conductive adhesive.
Patent Document 1: Japanese Laid-Open Patent Publication No. 2003-101167
Patent document 2: Japanese Laid-Open Patent Publication No. 2000-58996

JP 2001 156418 A (cf. the preamble of claim 1) discloses a compound flexible wiring board, its manufacturing method, optoelectronic device, and electronic equipment. JP 2005 146043 Adiscloses an anisotropic conductive adhesive. US 4 731 282 A discloses an anisotropic-electroconductive adhesive film. JP 2006 268348 A discloses a composite flexible printed board.

### DISCLOSURE OF THE INVENTION

However, according to the method disclosed in patent document 1, the connector for connecting the flexible printed circuit boards is required. Therefore, the connecting structure of the flexible printed circuit board is complicated and the manufacturing costs are undesirably increased. Also, since an extra space is necessary by an amount corresponding to the thickness of the connector, the method cannot cope with miniaturization of electronic devices.

Furthermore, according to the method disclosed in patent document 2, the bumps increase the thickness of the connecting sections on the first and second flexible printed circuit boards. Therefore, the flexibility of the flexible printed circuit board is reduced, and thus the invention cannot cope with miniaturization of electronic devices.

Accordingly, it is an objective of the present invention to provide a flexible circuit board that reduces the manufacturing costs, has satisfactory flexibility, and copes with miniaturization of electronic devices, and to provide a method for manufacturing the same.

To achieve the above objective, the present invention provides a flexible printed circuit board according to claim 1 of the claims appended hereto.

With this structure, a connector for connecting the first flexible printed circuit board to the second flexible printed circuit board is unnecessary. Therefore, the structure for connecting the first flexible printed circuit board to the second flexible printed circuit board is simplified, which reduces the manufacturing costs of the flexible printed circuit board. Furthermore, a space for connecting the first flexible printed circuit board to the second flexible printed circuit board is unnecessary. Therefore, the flexible printed circuit board that copes with miniaturization of electronic devices is obtained.

Moreover, since bumps are unnecessary, the thickness of the connecting sections of the first and second flexible printed circuit boards is reduced. This improves the flexibility of the flexible printed circuit board, which is further advantageous for miniaturization of electronic devices.

Furthermore, the first and second flexible printed circuit boards having different sizes can be connected to each other. As a result, the number of the first flexible printed circuit boards (or the second flexible printed circuit boards) manufactured from a single flexible printed circuit board substrate is increased. This reduces the disposal volume of the flexible printed circuit board substrate, and suppresses the manufacturing costs of the flexible printed circuit board.

In the above-mentioned flexible printed circuit board, the first flexible printed circuit board is preferably a single-sided flexible printed circuit board, which has the first conductor trace on one side of a base material, and the second flexible printed circuit board is preferably a double-sided flexible printed circuit board, which has the second conductor trace on each side of a base material. With this structure, the flexible printed circuit board having a complex form and configuration can be manufactured in accordance with application.

In the above-mentioned flexible printed circuit board, the diameter of the conductive fine particles is preferably less than or equal to 1 µm, and the aspect ratio is preferably greater than or equal to 5. With this structure, the probability is increased that the conductive fine particles contact each other when the adhesive layer is formed using the anisotropic conductive adhesive containing the conductive fine particles. Thus, the first conductor trace can be connected to the second conductor trace without increasing the proportion of the conductive fine particles, or even if the proportion is reduced. As a result, the manufacturing costs of the flexible printed circuit board is further reduced.

In the above-mentioned flexible printed circuit board, before the first and second conductor traces are connected to each other, the conductive fine particles are preferably oriented in the thickness direction of the adhesive layer. With this structure, since the conductive resistance is increased in a direction along the surface of the adhesive layer formed of the anisotropic conductive adhesive, insulation between the adjacent conductor traces is maintained and the adjacent conductor traces are prevented from being short-circuited. Meanwhile, since the conductive resistance is reduced in the thickness direction of the anisotropic conductive adhesive, several first conductor traces and the second conductor traces can be simultaneously and independently connected electrically.

In addition, the orientation of the conductive fine particles might be disarrayed by the pressure applied when connecting the first conductor trace to the second conductor trace. In this case, by using the conductive fine particles having the length smaller than the distance between the first conductor trace and the second conductor trace, the insulation between the adjacent conductor traces is maintained and the adjacent conductor traces are prevented from being short-circuited. Thus, the first conductor trace can be electrically connected to the second conductor trace. The conductive fine particles are preferably oriented in the thickness direction of the anisotropic conductive adhesive even after the first and second conductor traces are connected to each other.

In the above-mentioned flexible printed circuit board, at least one of the first and second conductor traces is preferably formed of a conductive paste. With this structure, even if the heights of the first and second conductor traces made of the conductive paste differ from each other, several first conductor traces and second conductor traces are reliably connected. Also, the manufacturing costs of the flexible printed circuit board are reduced.

In the above-mentioned flexible printed circuit board, the first and second flexible printed circuit boards are preferably provided with a reinforcing member for reinforcing a section connected to the adhesive layer. With this structure, the connecting portion between the first and second connecting portions and the anisotropic conductive adhesive is reinforced, thus preventing the anisotropic conductive adhesive from being undesirably separated from the first and second connecting portions. Accordingly, the reliability of the connection between the first and second conductor traces is improved.

To achieve the above objective, a second aspect of the present invention is a method for manufacturing a flexible printed circuit board according to claim 7 of the claims appended hereto.

### BRIEF DESCRIPTION OF THE DRAWINGS

Fig. 1 is a schematic view illustrating an entire configuration of a flexible printed circuit board according to a preferred embodiment;
Fig. 2 is a cross-aectional view taken along line 2-2 of Fig. 1;
Fig. 3 is a cross-sectional view illustrating a schematic configuration of a first flexible printed circuit board forming the flexible printed circuit board according to the preferred embodiment;
Fig. 4 is a cross-sectional view illustrating a schematic configuration of a second flexible printed circuit board forming the flexible printed circuit board according to the preferred embodiment;
Fig. 5 is a partially enlarged cross-sectional view illustrating conductive fine particles used for an anisotropic conductive adhesive of the flexible printed circuit board according to the preferred embodiment;
Fig. 6 is a schematic view illustrating a reinforcing member used for the flexible printed circuit board according to the preferred embodiment; and
Fig. 7 is a cross-sectional view taken along line 7-7 of Fig. 6.

### BEST MODE FOR CARRYING OUT THE INVENTION

A flexible printed circuit board 1 according to one embodiment of the present invention will now be described. The flexible printed circuit board 1 is formed by connecting a single-sided flexible printed circuit board and a double-sided flexible printed circuit board with each other.

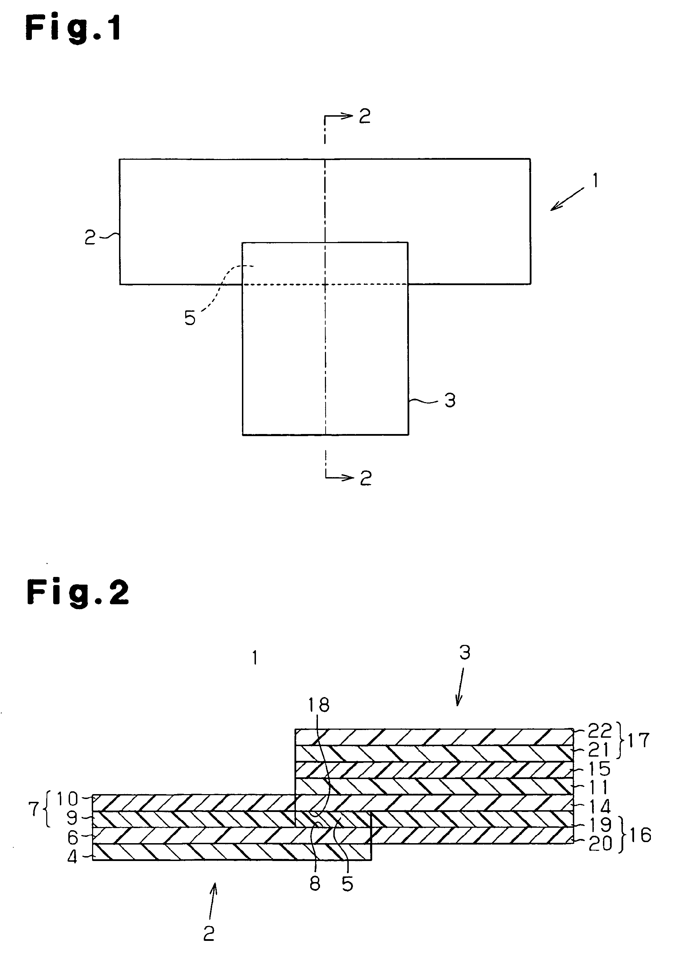

As shown in Figs. 1 and 2, the flexible printed circuit board 1 is formed by adhering a first flexible printed circuit board 2 and a second flexible printed circuit board 3 with an adhesive layer 5.

The first flexible printed circuit board 2 is a single-sided flexible printed circuit board and includes a base material 4, a first conductor trace (conductor circuit) 6, which covers the surface of the base material 4, and an insulating layer, which is a cover lay film 7 in this embodiment. The cover lay film 7 covers the surface of the first conductor trace 6. In this specification, the insulating layer includes, for example, the cover lay film 7, which is provided to protect the first conductor trace 6, and a cover coat layer, which will be described later.

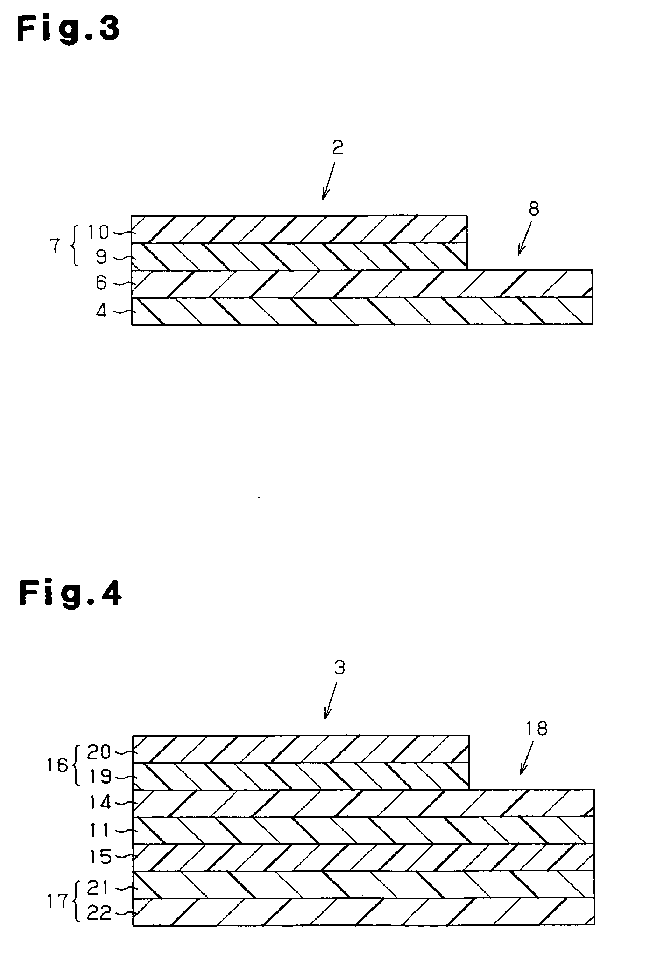

As shown in Fig. 3, the first flexible printed circuit board 2 includes an exposed portion, which is not covered by the cover lay film 7. The exposed portion forms a first connecting portion 8. The first connecting portion 8 of the first conductor trace 6 is electrically connected to a second conductor trace 14 (see Fig. 4) of the second flexible printed circuit board 3. The surface of the first connecting portion 8 is located at the same height as the first conductor trace 6.

The cover lay film 7 includes an adhesive layer 9 laminated on the first conductor trace 6 and a resin film 10 laminated on the adhesive layer 9.

The second flexible printed circuit board 3 is a double-sided flexible printed circuit board and includes a base material 11, second conductor traces 14, 15, which cover both sides of the base material 11, respectively, a cover lay film 16, which covers the surface of the second conductor trace 14, and a cover lay film 17, which covers the surface of the second conductor trace 15. The cover lay films 16, 17 serve as insulating layers.

As shown in Fig. 4, the second flexible printed circuit board 3 includes an exposed portion, which is not covered by the cover lay film 16. The exposed portion forms a second connecting portion 18. The second connecting portion 18 of the second conductor trace 14 is electrically connected to the first conductor trace 6 of the first flexible printed circuit board 2. The surface of the second connecting portion 18 is located at the same height as the second conductor trace 14.

The cover lay film 16 includes an adhesive layer 19, which is laminated on the second conductor trace 14, and a resin film 20, which is laminated on the adhesive layer 19. Also, the cover lay film 17 includes an adhesive layer 21, which is laminated on the conductor trace 15, and a resin film 22, which is laminated on the adhesive layer 21.

The base materials 4, 11 are formed of a resin film such as a polyester film, which has excellent flexibility and is widely used for flexible printed circuit boards. For example, a polyamide-based resin, a polyimide-based resin such as a polyimide resin and a polyamide-imide resin, and resin film made of polyethylene naphthalate are favorably used since these materials have a high heat resistance in addition to flexibility.

The first conductor trace 6 and the second conductor traces 14, 15 are all formed by laminating metal foil (such as copper foil) on the surface of the base material, which are then exposed to light and etched by a common method. However, the first conductor trace 6 and the second conductor traces 14, 15 are preferably formed by printing a conductive paste through screen printing and intaglio printing. With these methods, the processes of exposing to light and etching are unnecessary. Therefore, the manufacturing costs of the first and second flexible printed circuit boards 2, 3 (that is, the flexible printed circuit board 1) are reduced. Only one of the first and second conductor traces 6, 14 may be formed using the conductive paste.

The conductive paste may be a thermosetting conductive paste containing, for example, conductive powder, a binder resin, a curing agent and a solvent as main ingredients. The conductive powder may be, for example, silver, nickel, and copper. The binder resin may be, for example, a polyester resin, an epoxy resin, and a polyimide resin. When a polyester resin is used as the binder resin, for example, an isocyanate compound is used as the curing agent. When an epoxy resin is used as the binder resin, an amine compound or an imidazole compound is used as the curing agent. The solvent may be, for example, cellosolve, acetic acid butyl, cellosolve acetate, or butyl carbitol acetate. After applying the conductive paste on the surfaces of the base materials 4, 11 by screen printing, the binder resin is heated and cured to form the first conductor trace 6 and the second conductor traces 14, 15.

The same resin film as the base materials 4, 11 is used for the resin films 10, 20, 22. The adhesive layers 9, 19, 21 are preferably formed of, for example, a nylon adhesive, an epoxy resin adhesive, a butyral resin adhesive, or an acryl resin adhesive since these adhesives have excellent flexibility and heat resistance.

The first and second flexible printed circuit boards 2, 3 can be manufactured by the same method as the conventional method. For example, in a case of the second flexible printed circuit board 3, first, the conductive paste is printed on both sides of the base material 11 by screen printing to manufacture a double-sided board having the second conductor trace 14 (15) on each side. Next, a resin film with an adhesive layer is laminated on each side of the double-sided board, and the cover lay films 16, 17 each including two layers are adhered to complete the second flexible printed circuit board 3.

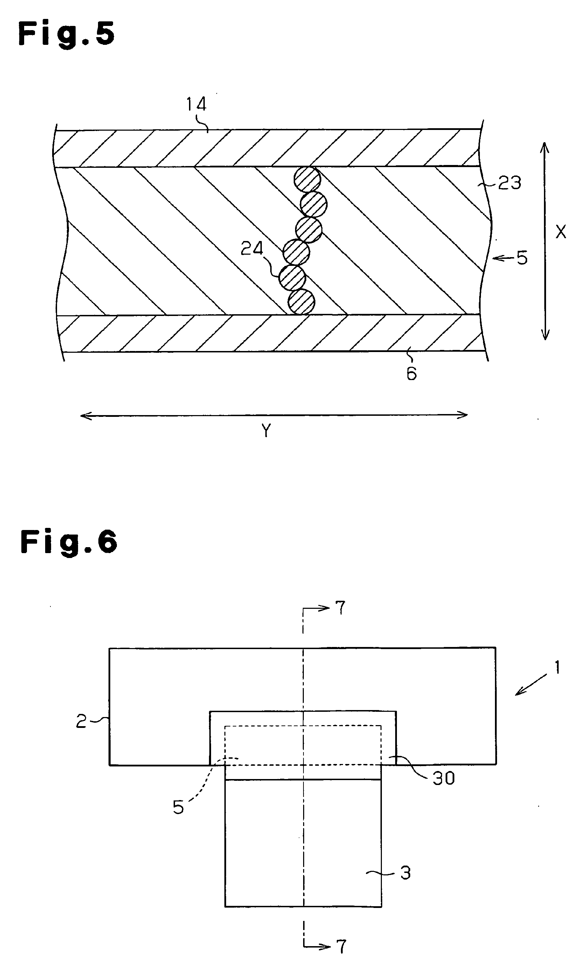

As shown in Fig. 5, the first conductor trace 6 is connected to the second conductor trace 14 via the adhesive layer 5 in the flexible printed circuit board 1. The adhesive layer 5 is formed of an anisotropic conductive adhesive containing conductive fine particles 24. The anisotropic conductive adhesive includes, for example, an insulating thermosetting resin 23 such as an epoxy resin as a main ingredient. The conductive fine particles 24 are dispersed in the thermosetting resin 23. The conductive fine particles 24 may be spherical metal fine particles or metal plated spherical resin particles. Furthermore, the conductive fine particles 24 may be, for example, metal fine particles having the shape of high aspect ratio. For example, minute metal fine particles may be connected in a straight-chained form or needle-shaped metal fine particles may be used. The aspect ratio is the ratio between the minor axis of the conductive fine particles 24 (the length of cross-section of the conductive fine particles 24) and the major axis of the conductive fine particles 24 (the length of the conductive fine particles 24).

In the preferred embodiment, the adhesive layer 5 is formed of the anisotropic conductive adhesive containing the conductive fine particles 24. The first flexible printed circuit board 2 is provided with the first connecting portion 8, which is connected to the adhesive layer 5. The first connecting portion is located at substantially the same height as the first conductor trace 6. The second flexible printed circuit board is provided with the second connecting portion 18, which is connected to the adhesive layer 5. The second connecting portion is located at substantially the same height as the second conductor trace 14.

With this structure, the first flexible printed circuit board 2 and the second flexible printed circuit board 3 are connected with each other via the adhesive layer 5. Therefore, a connector for connecting the first flexible printed circuit board 2 to the second flexible printed circuit board 3 is unnecessary. This simplifies the structure for connecting the first flexible printed circuit board 2 to the second flexible printed circuit board 3, which reduces the manufacturing costs of the flexible printed circuit board 1. Furthermore, a space for connecting the first flexible printed circuit board 2 to the second flexible printed circuit board 3 is unnecessary. Therefore, the flexible printed circuit board 1 that copes with miniaturization of electronic devices is obtained.

Moreover, since bumps are unnecessary, the thickness of the connecting portion of the first and second flexible printed circuit boards 2, 3 is reduced. This improves the flexibility of the flexible printed circuit board 1, which is further advantageous for miniaturization of electronic devices.

Furthermore, the first and second flexible printed circuit boards 2, 3 having different sizes can be connected to each other. As a result, the number of the first flexible printed circuit board 2 (or the second flexible printed circuit board 3) manufactured from a single flexible printed circuit board substrate is increased. This reduces the disposal volume of the flexible printed circuit board substrate, and suppresses the manufacturing costs of the flexible printed circuit board 1.

The flexible printed circuit board 1 having a complex form and configuration can be manufactured in accordance with application, using the single-sided flexible printed circuit board as the first flexible printed circuit board 2 and the double-sided flexible printed circuit board as the second flexible printed circuit board 3.

In a case where many minute conductive fine particles 24 are connected in straight-chained form or needle-shaped conductive fine particles 24 are used, the minor axis of the straight-chained or needle-shaped conductive fine particles 24 is desirably less than or equal to 1 µm, and the aspect ratio is desirably greater than or equal to 5. In this case, the probability is increased that the conductive fine particles 24 contact each other when the adhesive layer 5 is formed using the anisotropic conductive adhesive containing the conductive fine particles 24. Thus, the first conductor trace 6 can be connected to the second conductor trace 14 without increasing the proportion of the conductive fine particles 24, or even if the proportion is reduced. As a result, the manufacturing costs of the flexible printed circuit board 1 is further reduced.

The aspect ratio of the conductive fine particles 24 can be directly measured using CCD microscope. However, if the cross-section of the conductive fine particles 24 is not a circle, the maximum length of the cross-section is assumed to be the minor axis to obtain the aspect ratio of the conductive fine particles 24. Also, the conductive fine particles 24 are not necessarily in a straight-chained form, but may include curves and branches. In this case, the maximum length of the conductive fine particles 24 is assumed to be the major axis to obtain the aspect ratio of the conductive fine particles 24.

As shown in Fig. 5, before connecting the first and second conductor traces 6, 14 with each other, the conductive fine particles 24 are preferably oriented in the thickness direction by the magnetic field that is applied in the thickness direction (the direction of arrow X shown in Fig. 5) of the adhesive layer 5. With the conductive fine particles 24 oriented in this direction, since the conductive resistance is increased in a direction perpendicular to the thickness direction of the adhesive layer 5 (the direction along the surface, or the direction of arrow Y shown in Fig. 5), insulation between the adjacent conductor traces is maintained and the adjacent conductor traces are prevented from being short-circuited. Meanwhile, since the conductive resistance is reduced in the thickness direction of the adhesive layer 5, several first conductor traces 6 and the second conductor traces 14 can be simultaneously and independently connected electrically. Furthermore, even if the heights of the first and second conductor traces 6, 14 made of the conductive paste differ from each other, several first conductor traces 6 and second conductor traces 14 are reliably connected.

In addition, the orientation of the conductive fine particles 24 might be disarrayed by the pressure applied when connecting the first conductor trace 6 to the second conductor trace 14. In this case also, if the conductive fine particles 24 are oriented in the thickness direction of the adhesive layer 5 before the first and second conductor traces 6, 14 are connected to each other, the insulation between the adjacent conductor traces is maintained and the adjacent conductor traces are prevented from being short-circuited even if the conductive fine particles 24 having the length smaller than the distance between the first conductor trace 6 and the second conductor trace 14 are used. Thus, the first conductor trace 6 can be electrically connected to the second conductor trace 14. The conductive fine particles 24 are preferably oriented in the thickness direction of the adhesive layer 5 even after the first and second conductor traces 6, 14 are connected to each other.

The conductive fine particles 24 are preferably one kind of a ferromagnetic metal, an alloy of two or more kinds of ferromagnetic metals, an alloy of a ferromagnetic metal and other metal, or a complex containing a ferromagnetic metal. When such a ferromagnetic metal is used, a magnetic field is formed by magnetism of the metal itself. The conductive fine particles 24 are oriented by this magnetic field. This type of conductive fine particles 24 include, for example, nickel, iron, cobalt, and an alloy of two or more of these metals connected in a straight-chained form.

As a method for connecting the first flexible printed circuit board 2 to the second flexible printed circuit board 3, a method is employed in which the anisotropic conductive adhesive is arranged between the flexible printed circuit boards 2, 3, and the anisotropic conductive adhesive is heated and pressurized to cure the thermosetting resin 23 in the adhesive.

More specifically, the anisotropic conductive adhesive containing the thermosetting resin 23 such as an epoxy resin as a main ingredient is arranged on the first connecting portion 8 of the first flexible printed circuit board 2. Then, a predetermined pressure is applied to the anisotropic conductive adhesive toward the first flexible printed circuit board 2. As a result, the anisotropic conductive adhesive is connected to the first connecting portion 8. Thus, the anisotropic conductive adhesive is temporarily adhered to the first flexible printed circuit board 2.

Subsequently, the second flexible printed circuit board 3 is arranged such that the second connecting portion 18 faces downward. In this state, the anisotropic conductive adhesive is arranged between the first conductor trace 6 of the first flexible printed circuit board 2 and the second conductor trace 14 of the second flexible printed circuit board 3. The position of the first flexible printed circuit board 2 and the second flexible printed circuit board 3 is then determined.

Next, the anisotropic conductive adhesive is arranged on the second connecting portion 18 of the second flexible printed circuit board 3. With the anisotropic conductive adhesive heated to a predetermined curing temperature, a predetermined pressure is applied to the second flexible printed circuit board 3 toward the first flexible printed circuit board 2 so that the anisotropic conductive adhesive is melted. Since the anisotropic conductive adhesive contains the thermosetting resin 23 as a main ingredient, when heated to the above mentioned curing temperature, the anisotropic conductive adhesive is softened temporarily, but is cured by continuing to heat. After a predetermined time period has elapsed, heating of the anisotropic conductive adhesive is stopped to cool the adhesive. Thus, the first conductor trace 6 is connected to the second conductor trace 14 via the anisotropic conductive adhesive. The flexible printed circuit board 1 is manufactured in this manner.

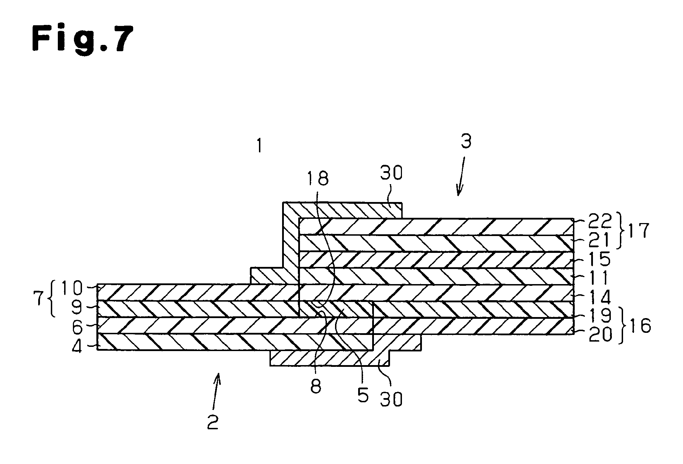

As shown in Figs. 6 and 7, reinforcing members 30 may be provided on the outer surface of the base material 4 of the first flexible printed circuit board 2 and the outer surface of the cover lay film 17 of the second flexible printed circuit board 3. With this configuration, the connection between the first and second connecting portions 8, 18 and the anisotropic conductive adhesive is reinforced, thus preventing the anisotropic conductive adhesive from being undesirably separated from the first and second connecting portions 8, 18. Accordingly, the reliability of the connection between the first and second conductor traces 6, 14 is improved. As the reinforcing members 30, for example, a glass epoxy resin, metal, and a polyimide resin are favorably used.

The present invention is not limited to the above embodiment, but can be modified in various forms based on the spirit of the present invention. The modifications are not excluded from the scope of the present invention.

In the preferred embodiment, instead of the single-sided flexible printed circuit board or the double-sided flexible printed circuit board, a multilayer flexible printed circuit board may be used.

For example, in a case where a single-sided flexible printed circuit board as shown in Fig. 3 is used as the first flexible printed circuit board 2, a multilayer flexible printed circuit board provided with conductive circuit layers is used as the second flexible printed circuit board 3. The multilayer flexible printed circuit board has a conductor trace corresponding to the second conductor trace 14. The multilayer flexible printed circuit board may be provided with a connecting portion corresponding to the second connecting portion 18. Then, the first conductor trace 6 may be connected to the conductor trace corresponding to the second conductor trace 14 via an anisotropic conductive adhesive.

Furthermore, in a case where the double-sided flexible printed circuit board shown in Fig. 4 is used as the second flexible printed circuit board, the multilayer flexible printed circuit board provided with conductive circuit layers is used as the first flexible printed circuit board 2. The multilayer flexible printed circuit board has a conductor trace corresponding to the first conductor trace 6. The multilayer flexible printed circuit board may be provided with a connecting portion corresponding to the first connecting portion 8. Then, the conductor trace corresponding to the first conductor trace 6 may be connected to the second conductor trace 14 via an anisotropic conductive adhesive.

In this case, the multilayer flexible printed circuit board may be provided with the reinforcing member 30. Furthermore, in the multilayer flexible printed circuit board, the conductor trace corresponding to the first conductor trace 6 (or the conductor trace corresponding to the second conductor trace 14) may be formed by applying a conductive paste by screen printing.

Moreover, for example, a rigid-flex printed circuit board including a flexible printed circuit board and a rigid printed circuit board may be used as the multilayer flexible printed circuit board.

Also, instead of the conductive paste, metal foil (such as copper foil) may be adhered to one side of the base material 4 (or both sides of the base material 11) via the adhesive layer. The first conductor trace 6 (or the second conductor traces 14, 15) may then be formed of the metal foil.

Furthermore, instead of the cover lay films 7, 16, 17, a polyimide cover coat ink may be applied to the surfaces of the first conductor trace 6 and the second conductor traces 14, 15 by screen printing.

### INDUSTRIAL APPLICABILITY

Applications of the present invention include a flexible printed circuit board used as a component of electronic devices and a method for manufacturing the same.

## Claims

1. A flexible printed circuit board (1) comprising: a first flexible printed circuit board (2) including a first conductor trace (6) and a first insulating layer (7) that covers the surface of the first conductor trace (6); and a second flexible printed circuit board (3) including a second conductor trace (14) and a second insulating layer (16) that covers the surface of the second conductor trace (14), the second conductor trace (14) being connected to the first conductor trace (6) via an adhesive layer (5),
wherein the adhesive layer (5) is formed of an anisotropic conductive adhesive containing conductive fine particles (24), the first flexible printed circuit board (2) is provided with a first connecting portion (6), which is connected to the adhesive layer (5), the first connecting portion (8) being located at the same height as the first conductor trace (6), and the second flexible printed circuit board (3) is provided with a second connecting portion (18), which is connected to the adhesive layer (5), the second connecting portion (18) being located at the same height as the second conductor trace (14),
wherein the first connecting portion (6) consists of an exposed portion of the first conductor trace (6) that is not covered by the first insulating layer (7) and being located at the end of the first flexible printed circuit board (2), and the second connecting portion (18) consists of an exposed portion of the second conductor trace (14) that is not covered by the second insulating layer (16) and being located at the end of the second flexible printed circuit board (3),
**characterized in that**:
the first conductor trace (6) and the second conductor trace (14) are all formed of metal foil;
the length of the conductive fine particles (24) is smaller than the distance between adjacent first conductor traces (6), which are adjacent to each other along the surface of the first flexible printed circuit board (2), or the distance between adjacent second conductor traces (14), which are adjacent to each other along the surface of the second flexible printed circuit board (3);
the first and second printed circuit boards (2,3) being connected to each other have different sizes.

2. The flexible printed circuit board (1) according to claim 1, wherein the first flexible printed circuit board (2) is a single-sided flexible printed circuit board, which has the first conductor trace (6) on one side of a base material (4), and the second flexible printed circuit board (3) is a double-sided flexible printed circuit board, which has the second conductor trace (14, 15) on each side of a base material (11).

3. The flexible printed circuit board (1) according to claim 1 or 2, wherein the diameter of the conductive fine particles (24) is less than or equal to 1µm, and the aspect ratio is greater than or equal to 5, wherein the aspect ratio is the ratio between the minor axis of the conductive fine particles (24) and the major axis of the conductive particles (24).

4. The flexible printed circuit board (1) according to claim 3, wherein before the first and second conductor traces (6, 14) are connected to each other, the conductive fine particles (24) are oriented in the thickness direction of the adhesive layer (5).

5. The flexible printed circuit board (1) according to claim 4, wherein at least one of the first and second conductor traces (6,14) is formed of a conductive paste.

6. The flexible printed circuit board (1) according to any one of claims 1 to 5, wherein the first and second flexible printed circuit boards (2,3) are provided with a reinforcing member (30) for reinforcing a section connection to the adhesive layer (5).

7. A method for manufacturing a flexible printed circuit board (1), the method comprising:
forming an anisotropic conductive adhesive layer (5) containing a thermosetting resin (23) as a main ingredient on a first connecting portion (8), the first connecting portion (8) being provided on a first flexible printed circuit board (2), including a first conductive trace (6) and a first insulating layer (7) that covers the surface of the first conductor trace (6) at a position the same height as the first conductor trace (6), thereby connecting the anisotropic conductive adhesive layer (5) to the first connecting portion (8);
determining the position of the first flexible printed circuit board (2) and a second flexible printed circuit board (3) including a second conductor trace (14) and a second insulating layer (16) that covers the surface of the second conductor trace (14) with the anisotropic conductive adhesive layer (5) being arranged between the first and second flexible printed circuit boards (2, 3) for connecting the first flexible printed circuit board to the second flexible printed circuit board (3);
forming the anisotropic conductive adhesive layer (5) on a second connecting portion (18), which is provided on the second flexible printed circuit board (3) at a position the same height as the second conductor trace (14); and
connecting the first conductor trace (6) to the second conductor trace (14) by heating and pressurizing so that the thermosetting resin (23) is cured,
wherein the first connecting portion (8) consists of an exposed portion of the first conductor trace (6) that is not covered by the first insulating layer (7) and is located at the end of the first flexible printed circuit board (2), and;
the second connecting portion (18) consists of an exposed portion of the second conductor trace (14) that is not covered by the second insulating layer (16) and is located at the end of the second flexible printed circuit board (3),
**characterized in that**:
the first conductor trace (6) and the second conductor trace (14) are all formed of metal foil;
the anisotropic conductive adhesive layer (5) is formed of an anisotropic conductive adhesive containing conductive fine particles (24), the length of the conductive fine particles (24) is smaller than the distance between adjacent first conductor traces, which are adjacent to each other along the surface of the first flexible printed circuit board (2), or the distance between adjacent second conductor traces (14), which are adjacent to each other along the surface of the second flexible printed circuit board (3);
the first and second flexible printed circuit boards (2,3) connected to each other have different sizes.

## Patentansprüche

1. Flexible Platine (1) mit: einer ersten flexiblen Platine (2) mit einer ersten Leiterbahn (6) und einer ersten Isolierschicht (7), welche die Oberfläche der ersten Leiterbahn (7) bedeckt, und einer zweiten flexiblen Platine (3) mit einer zweiten Leiterbahn (14) und einer zweiten Isolierschicht (16), welche die Oberfläche der zweiten Leiterbahn (14) bedeckt, wobei die zweite Leiterbahn (14) mit der ersten Leiterbahn (6) durch eine Klebeschicht (5) verbunden ist,
wobei die Klebeschicht (5) aus einem anisotropen leitenden Kleber ausgebildet ist, der leitende feine Teilchen (24) enthält, wobei die erste flexible Platine (2) mit einem ersten Verbindungsabschnitt (6) versehen ist, der mit der Klebeschicht (5) verbunden ist, wobei der erste Verbindungsabschnitt (8) an der gleichen Höhe wie die erste Leiterbahn (6) angeordnet ist, und wobei die zweite flexible Platine (3) mit einem zweiten Verbindungsabschnitt (18) verbunden ist, der mit der Klebeschicht (5) verbunden ist, wobei der zweite Verbindungsabschnitt (18) an der gleichen Höhe wie die zweite Leiterbahn (14) angeordnet ist,
wobei der erste Verbindungsabschnitt (6) aus einem offenen Abschnitt der ersten Leiterbahn (6) besteht, der nicht durch die erste Isolierschicht (7) bedeckt ist und der am Ende der ersten flexiblen Platine (2) angeordnet ist, und wobei der zweite Verbindungsabschnitt (18) aus einem offenen Abschnitt der zweiten Leiterbahn (14) besteht, der nicht durch die zweite Isolierschicht (16) bedeckt ist und der am Ende der zweiten flexiblen Platine (3) angeordnet ist,
**dadurch gekennzeichnet, dass**:
die erste Leiterbahn (6) und die zweite Leiterbahn (14) alle aus Metallfolie ausgebildet sind,
die Länge der leitenden feinen Teilchen (24) kleiner ist als der Abstand zwischen benachbarten ersten Leiterbahnen (6), die zueinander entlang der Oberfläche der ersten flexiblen Platine (2) benachbart sind, oder als der Abstand zwischen benachbarten zweiten Leiterbahnen (14), die entlang der Oberfläche der zweiten flexiblen Platine (3) zueinander benachbart sind,
wobei die ersten und zweiten Platinen (2, 3), die miteinander verbunden sind, verschiedene Größen aufweisen.

2. Flexible Platine (1) nach Anspruch 1, bei der die erste flexible Platine (2) eine einseitige flexible Platine ist, welche die erste Leiterbahn (6) auf einer Seite eines Grundmaterials (4) aufweist, und die zweite flexible Platine (3) eine doppelseitige flexible Platine ist, welche die zweite Leiterbahn (14, 15) auf jeder Seite eines Grundmaterials (11) aufweist.

3. Flexible Platine (1) nach Anspruch 1 oder 2, bei welcher der Durchmesser der leitenden feinen Teilchen (24) kleiner oder gleich 1 µm und das Aspektverhältnis größer oder gleich 5 ist, wobei das Aspektverhältnis das Verhältnis zwischen der kleinen Achse der leitenden feinen Teilchen (24) und der großen Achse der leitenden Teilchen (24) ist.

4. Flexible Platine (1) nach Anspruch 3, bei der, bevor die ersten und zweiten Leiterbahnen (6, 14) miteinander verbunden werden, die leitenden feinen Teilchen (24) in der Dickenrichtung der Klebeschicht (5) ausgerichtet werden.

5. Flexible Platine (1) nach Anspruch 4, bei der wenigstens eine unter der ersten und der zweiten Leiterbahn (6, 14) aus einer leitenden Paste ausgebildet ist.

6. Flexible Platine (1) nach einem der Ansprüche 1 bis 5, bei der die ersten und zweiten flexiblen Platinen (2, 3) mit einem Verstärkungselement (30) zur Verstärkung einer Abschnittsverbindung mit der Klebeschicht (5) versehen sind.

7. Verfahren zum Herstellen einer flexiblen Platine (1), das Verfahren mit:
dem Ausbilden einer anisotropen leitenden Klebeschicht (5) mit einem bei Erwärmung aushärtenden Harz (23) als Hauptbestandteil auf einem ersten Verbindungsabschnitt (8), wobei der erste Verbindungsabschnitt (8) auf einer ersten flexiblen Platine (2) vorgesehen ist, die eine erste Leiterbahn (6) und eine erste Isolierschicht (7) aufweist, welche die Oberfläche der ersten Leiterbahn (6) bei einer Position bedeckt, welche die gleiche Höhe wie die erste Leiterbahn (6) hat, um somit die anisotrope leitende Klebeschicht (5) mit dem ersten Verbindungabschnitt (8) zu verbinden,
dem Bestimmen der Position der ersten flexiblen Platine (2) und einer zweiten flexiblen Platine (3) mit einer zweite Leiterbahn (14) und einer zweiten Isolierschicht (16), welche die Oberfläche der zweiten Leiterbahn (14) bedeckt, wobei die anisotrope leitende Klebeschicht (5) zwischen der ersten und der zweiten flexiblen Platine (2, 3) angeordnet ist, um die erste flexible Platine mit der zweiten flexiblen Platine (3) zu verbinden,
dem Ausbilden der anisotropen leitenden Klebeschicht (5) auf einem zweiten Verbindungsabschnitt (18), der auf der zweiten flexiblen Platine (3) bei einer Position an der gleichen Höhe wie die zweite Leiterbahn (14) vorgesehen ist, und
dem Verbinden der ersten Leiterbahn (6) mit der zweiten Leiterbahn (14) durch Erhitzen und unter Druck Setzen, so dass das bei Wärme aushärtende Harz (23) ausgehärtet wird,
wobei der erste Verbindungsabschnitt (8) aus einem offenen Abschnitt der ersten Leiterbahn (6) besteht, der nicht durch die erste Isolierschicht (7) bedeckt ist und der am Ende der ersten flexiblen Platine (2) angeordnet ist, und
wobei der zweite Verbindungsabschnitt (18) aus einem offenen Abschnitt der zweiten Leiterbahn (14) besteht, der nicht durch die zweite Isolierschicht (16) bedeckt ist und der am Ende der zweiten flexiblen Platine (3) angeordnet ist,
**dadurch gekennzeichnet, dass**:
die erste Leiterbahn (6) und die zweite Leiterbahn (14) alle aus Metallfolie ausgebildet sind,
die anisotrope leitende Klebeschicht (5) aus einem anisotropen leitenden Kleber hergestellt ist, der leitende feine Teilchen (24) enthält, wobei die Länge der leitenden feinen Teilchen (24) kleiner ist als der Abstand zwischen benachbarten ersten Leiterbahnen, die zueinander entlang der Oberfläche der ersten flexiblen Platine (2) benachbart sind, oder als der Abstand zwischen benachbarten zweiten Leiterbahnen (14), die zueinander entlang der Oberfläche der zweiten flexiblen Platine (3) benachbart sind,
wobei die ersten und zweiten flexiblen Platinen (2, 3), die miteinander verbunden sind, verschiedene Größen aufweisen.

## Revendications

1. Carte de circuit imprimé flexible (1) comprenant : une première carte de circuit imprimé flexible (2) comprenant un premier conducteur (6) et une première couche isolante (7) qui couvre la surface du premier conducteur (6) ; et une deuxième carte de circuit imprimé flexible (3) comprenant un deuxième conducteur (14) et une deuxième couche isolante (16) qui couvre la surface du deuxième conducteur (14), le deuxième conducteur (14) étant connecté au premier conducteur (6) via une couche adhésive (5),
dans laquelle la couche adhésive (5) est formée d'un adhésif conducteur anisotrope contenant des particules fines conductrices (24), la première carte de circuit imprimé flexible (2) est pourvue d'une première partie de connexion (6), qui est connectée à la couche adhésive (5), la première partie de connexion (8) étant située à la même hauteur que le premier conducteur (6), et la deuxième carte de circuit imprimé flexible (3) est pourvue d'une deuxième partie de connexion (18), qui est connectée à la couche adhésive (5), la deuxième partie de connexion (18) étant située à la même hauteur que le deuxième conducteur (14),
dans laquelle la première partie de connexion (6) est constituée d'une partie exposée du premier conducteur (6) qui n'est pas couverte par la première couche isolante (7) et étant située à l'extrémité de la première carte de circuit imprimé flexible (2), et la deuxième partie de connexion (18) est constituée d'une partie exposée du deuxième conducteur (14) qui n'est pas couverte par la deuxième couche isolante (16) et étant située à l'extrémité de la deuxième carte de circuit imprimé flexible (3),
**caractérisée en ce que** :
le premier conducteur (6) et le deuxième conducteur (14) sont tous deux formés de feuille métallique ;
la longueur des particules fines conductrices (24) est inférieure à la distance entre des premiers conducteurs adjacents (6), qui sont mutuellement adjacents le long de la surface de la première carte de circuit imprimé flexible (2), ou la distance entre des deuxièmes conducteurs adjacents (14), qui sont mutuellement adjacents le long de la surface de la deuxième carte de circuit imprimé flexible (3) ;
les première et deuxième cartes de circuit imprimé (2, 3) étant mutuellement connectées ont des tailles différentes.

2. Carte de circuit imprimé flexible (1) selon la revendication 1, dans laquelle la première carte de circuit imprimé flexible (2) est une carte de circuit imprimé flexible simple face, qui a le premier conducteur (6) sur une face d'un matériau de base (4), et la deuxième carte de circuit imprimé flexible (3) est une carte de circuit imprimé flexible double face, qui a le deuxième conducteur (14, 15) sur chaque face d'un matériau de base (11).

3. Carte de circuit imprimé flexible (1) selon la revendication 1 ou 2, dans laquelle le diamètre des particules fines conductrices (24) est inférieur ou égal à 1 µm, et le facteur de forme est supérieur ou égal à 5, dans laquelle le facteur de forme est le rapport entre le petit axe des particules conductrices fines (24) et le grand axe des particules conductrices (24).

4. Carte de circuit imprimé flexible (1) selon la revendication 3, dans laquelle avant que les premier et deuxième conducteurs (6, 14) soient connectés mutuellement, les particules fines conductrices (24) sont orientées dans la direction de l'épaisseur de la couche adhésive (5).

5. Carte de circuit imprimé flexible (1) selon la revendication 4, dans laquelle au moins un des premier et deuxième conducteurs (6, 14) est formé d'une pâte conductrice.

6. Carte de circuit imprimé flexible (1) selon l'une quelconque des revendications 1 à 5, **caractérisée en ce que** les première et deuxième cartes de circuit imprimé flexibles (2, 3) sont pourvues d'un élément de renforcement (30) pour renforcer une connexion de section à la couche adhésive (5).

7. Procédé pour fabriquer une carte de circuit imprimé flexible (1), le procédé comprenant :
la formation d'une couche adhésive conductrice anisotrope (5) contenant une résine thermodurcissable (23) en tant que composant principal sur une première partie de connexion (8), la première partie de connexion (8) étant disposée sur une première carte de circuit imprimé flexible (2), comprenant un premier conducteur (6) et une première couche isolante (7) qui couvre la surface du premier conducteur (6) à une position à la même hauteur que le premier conducteur (6), de manière à connecter la couche adhésive conductrice anisotrope (5) à la première partie de connexion (8) ;
la détermination de la position de la première carte de circuit imprimé flexible (2) et une deuxième carte de circuit imprimé flexible (3) comprenant un deuxième conducteur (14) et une deuxième couche isolante (16) qui couvre la surface du deuxième conducteur (14) avec la couche adhésive conductrice anisotrope (5) étant agencée entre les première et deuxième cartes de circuit imprimé flexibles (2, 3) pour connecter la première carte de circuit imprimé flexible à la deuxième carte de circuit imprimé flexible (3) ;
la formation de la couche adhésive conductrice anisotrope (5) sur une deuxième partie de connexion (18), qui est disposée sur la deuxième carte de circuit imprimé flexible (3) à une position à la même hauteur que le deuxième conducteur (14) ; et
la connexion du premier conducteur (6) au deuxième conducteur (14) par chauffage et mise sous pression de sorte que la résine thermodurcissable (23) soit durcie,
dans lequel la première partie de connexion (8) est constituée d'une partie exposée, du premier conducteur (6) qui n'est pas couverte par la première couche isolante (7) et est située à l'extrémité de la première carte de circuit imprimé flexible (2), et ;
la deuxième partie de connexion (18) est constituée d'une partie exposée du deuxième conducteur (14) qui n'est pas couverte par la deuxième couche isolante (16) et est située à l'extrémité de la deuxième carte de circuit imprimé flexible (3), **caractérisée en ce que** :
le premier conducteur (6) et le deuxième conducteur (14) sont tous formés de feuille métallique ;
la couche adhésive conductrice anisotrope (5) est formée d'un adhésif conducteur anisotrope contenant des particules fines conductrices (24), la longueur des particules fines conductrices (24) est inférieure à la distance entre des premiers conducteurs adjacents, qui sont mutuellement adjacents le long de la surface de la première carte de circuit imprimé flexible (2), ou la distance entre des deuxièmes conducteurs adjacents (14), qui sont mutuellement adjacents le long de la surface de la deuxième carte de circuit imprimé flexible (3) ;
les première et deuxième cartes de circuit imprimé flexibles (2, 3) connectées mutuellement ont des tailles différentes.
